# EUROPEAN PATENT SPECIFICATION

(11) **EP 2 954 091 B1**
(45) Date of publication and mention of the grant of the patent: **10.08.2022**
(21) Application number: 14700558.1
(22) Date of filing: 17.01.2014
(51) Int. Cl.: C23C 14/08, C23C 14/34, C22C 21/00

(54) **COATING METHOD FOR PRODUCING (AL,CR)2O3-BASED COATINGS WITH ENHANCED PROPERTIES**
BESCHICHTUNGSVERFAHREN ZUR HERSTELLUNG VON (AL,CR)2O3-BASIERTEN BESCHICHTUNGEN MIT VERBESSERTEN EIGENSCHAFTEN
PROCÉDÉ DE REVÊTEMENT POUR LA PRODUCTION DE REVÊTEMENTS À BASE DE (AL,CR)2O3 DOTÉS DE PROPRIÉTÉS AMÉLIORÉES

(30) Priority: 18.01.2013 US 201361754025 P
(43) Date of publication of application: 16.12.2015
(73) Proprietor: Oerlikon Surface Solutions AG, Pfäffikon, 8808 Pfäffikon SZ (CH)
(72) Inventor: KOLLER, Christian Martin, A-8793 Trofaiach (AT); RACHBAUER, Richard, 9556 Liebenfels (AT); POLCIK, Peter, A-6600 Reutte (AT); RAMM, Jürgen, CH-7304 Maienfeld (CH); PAULITSCH, Joerg, 2514 Möllersdorf (AT); MAYRHOFER, Paul Heinz, A-7311 Neckenmarkt (AT)
(74) Representative: Troesch Scheidegger Werner AG
(86) International application number: PCT/EP2014/000119
(87) International publication number: WO 2014/111264

(56) References cited:
- US-A1- 2009 269 600
- RAMM J ET AL: "Correlation between target surface and layer nucleation in the synthesis of Al-Cr-O coatings deposited by reactive cathodic arc evaporation", SURFACE AND COATINGS TECHNOLOGY, ELSEVIER, AMSTERDAM, NL, vol. 205, no. 5, 25 November 2010 (2010-11-25), pages 1356-1361, XP027507490, ISSN: 0257-8972, DOI: 10.1016/J.SURFCOAT.2010.08.152 [retrieved on 2010-11-19]

## Description

The present invention relates to a coating process for producing aluminium chromium oxide coatings by using targets comprising aluminium and chromium as main component and additionally boron and/or iron as minor component. In terms of the present description aluminium chromium oxide coatings are referred to (Al,Cr)₂O₃, if they are produced without additional dopants, or referred to (Al,Cr)₂O₃-based, if they comprise additional dopants, more particularly referred to Al-Cr-B-O or Al-Cr-Fe-O if they are produced with B or Fe as dopant.

### State of the art

(Al,Cr)₂O₃ coatings exhibiting corundum structure (a-phase) are known for their outstanding mechanical, tribological and thermal properties. However, stabilising the desired corundum structure during deposition by using low temperature physical vapour processes, like for example cathodic arc evaporation, turned out to be challenging, particularly if Al/Cr metallic ratios of 2 or more in the oxide coatings want to be attained. Furthermore, recent studies on depositing (Al_{0.7}Cr_{0.3})₂O₃ showed that due to the reactive process in oxygen atmosphere aluminium rich oxide islands are formed at the target surface, influencing the arcing behaviour as well as the resulting film quality. This problem can be solved, according to the state of the art, by using Al-Cr targets with more than 80 at.-% Al content. However, it is known that an Al/Cr ratio of 4 or more in the (Al,Cr)₂O₃ or (Al,Cr)₂O₃-based oxide coating prevents the formation of (Al,Cr)₂O₃ stable corundum structures in the coating.

As an example US 2009/0269600 A1 discloses a method for producing oxidic layers by means of physical vapor deposition PVD wherein the oxidic layer has a proportion of more than 70 at% aluminum oxide, e.g. 85% aluminium oxide, in corundum structure and at least one of the elements in the atomic percentage indicated hereafter: Cr 10 to 20; Fe: 5 to 15, B < 3, and further elements mentioned.

### Objective of the present invention

The main objective of the present invention is to provide a coating method for producing (Al,Cr)₂O₃ coatings or (Al,Cr)₂O₃-based coatings exhibiting the desired (Al,Cr)₂O₃ corundum structure, the Al/Cr ratio in the coatings being preferably above 2, whereby the coating process is conducted at low process temperatures and accordingly at substrate temperatures preferably not higher than 600 °C.

### Description of the present invention

The invention is set forth in the appended claims.

Using targets comprising aluminium (Al) and chromium (Cr) as main components and additionally boron (B) and iron (Fe) as minor component it was possible to produce (Al,Cr)₂O₃ coatings or (Al,Cr)₂O₃-based coatings at low substrates temperatures of maximal 600 °C, which exhibit an increased amount of corundum structure in comparison with coatings deposited from targets which don't contain B and/or Fe as minor component according to X-ray examinations.

For attaining a better understanding of the invention, some examples of coating methods according to the present invention will be described in the following. The present invention is however not limited to the particular embodiments described below as examples of the present invention.

### Example 1:

AlCr-targets made by powder metallurgy and containing small amounts of B and/or Fe were used as source material for the synthesis of aluminium chromium oxide coatings in a coating chamber containing oxygen as a reactive gas. Different aluminium chromium oxide based coatings were formed by means of cathodic arc evaporation from the Al-Cr-B-targets as well as from Al-Cr-Fe-targets. Surprisingly, formation of oxide islands which is usually observed at the surface of AlCr-targets having an element composition AI:Cr 70:30 in atomic percentage by producing aluminium chromium oxide coatings at high oxygen flows (e.g. using oxygen flows of about 1000 sccm), doesn't occur in the same grade at the surface of the used Al-Cr-B-targets. Furthermore, it was possible to stabilize aluminium chromium oxide coatings in its solid solution α structure by using Al-Cr-Fe- or Al-Cr-B-Fe-targets.

For this reason, the inventors investigated the effects of using powder metallurgical AlCrFe- and Al-Cr-B-targetsduring deposition of aluminium chromium oxide based coatings by means of cathodic arc evaporation in oxygen atmosphere in more detail, the used targets having B and Fe contents ranging from 1 to 5 at%.

Increased B content was related to significant reduction of oxide formation on the surface of the AI-Cr-B-targets and a densification in the film morphology of the produced aluminium chromium oxide coatings. However, increased B contents resulted in a change in the structure detected by X-ray examinations. In contrast, the target oxide island formation could not be significantly influenced by using the AI-Cr-Fe-targets having Fe content ranging from 1 to 5 at%. Nevertheless, analysis of X-ray and transmission electron microscopy examinations indicated that even low amounts of Fe in the Al-Cr-Fe-targets can reduce the formation of cubic crystalline structure in the produced aluminium chromium oxide coatings, allowing in this way the production of more thermally stable α alumina structure.

For obtaining the results mentioned above several coating processes were carried out. In some cases it was used as process gas only oxygen and in other cases a mix gas containing oxygen and argon. Oxygen flows of for example 300 and 1000 sccm were used for the experiments and in each case the total pressure in the coating chamber was maintained constant (the total pressure value for these experiments was for example in some cases about 1.1 Pa). Bias voltage and arc current at the cathode were also maintained constant during coating process.

### Examples 2 and 3:

2:
AlCr-targets made by powder metallurgy and containing small amounts of B or Fe were used as cathodes for the evaporation by the cathodic arc and for the synthesis of aluminium chromium oxide coatings in a coating chamber containing oxygen as reactive gas. Different aluminium chromium oxide based coatings were formed by means of cathodic arc evaporation from the Al-Cr-B-targets as well as from Al-Cr-Fe-targets. The chemical compositions of the utilized targets and the synthesized coatings are summarized in Table 1. To achieve the best measurement accuracy, the composition measurements of the Al-Cr-O and Al-Cr-Fe-O coatings were performed by energy dispersive X-ray diffraction (EDX) and the compositional analysis of the Al-Cr-B-O coatings was performed by elastic recoil detection analysis (ERDA).

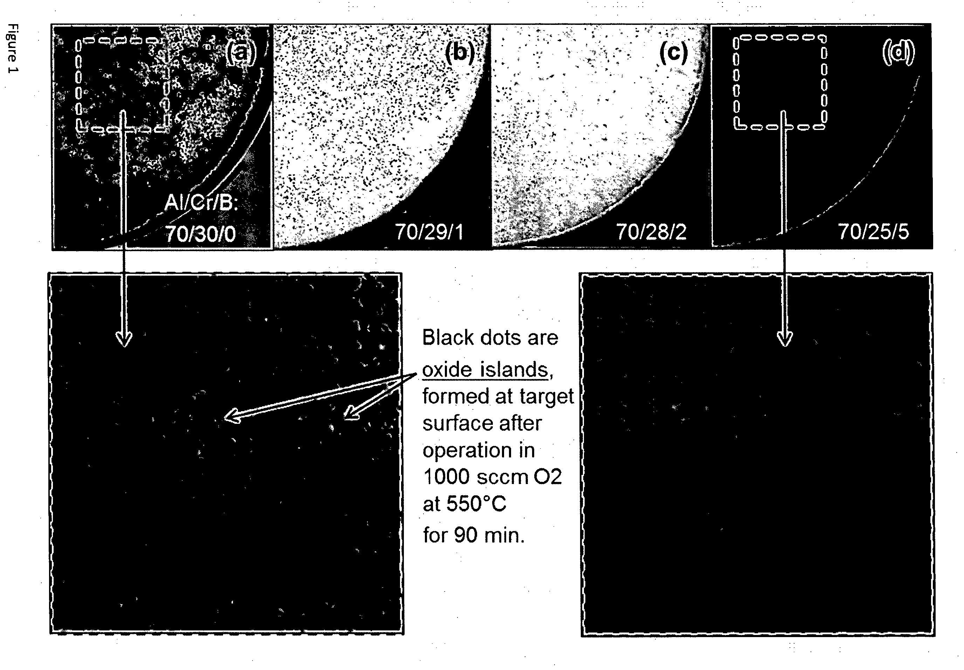

Usually, the formation of oxide islands is observed at the surface of Al-Cr-targets having an elemental composition of Al/Cr 70 at.% / 30 at.% utilizing high oxygen flows (e.g. using oxygen flows of about 1000 sccm). During synthesis of Al-Cr-B-O coatings from Al-Cr-B targets (Cr was replaced by 1, 2 or 5 at.% B in the target, respectively) at an oxygen flow of 1000 sccm the formation of oxide islands on the target surface was surprisingly not observed anymore. This is demonstrated by the SEM micrographs in Figure 1, which shows the target surface after operation at a process temperature of 550°C for 90 min for (a) Al-Cr 70/30 targets, as well as for Al-Cr-B targets with 70/29/1, 70/28/2, 70/25/5 in (b), (c), and (d), respectively.

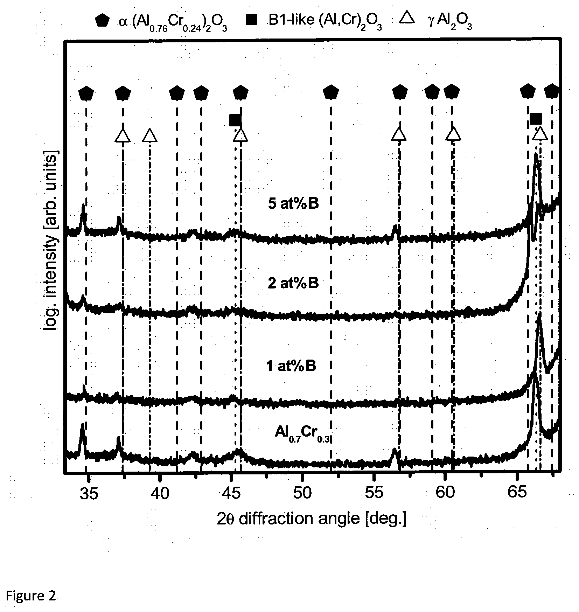

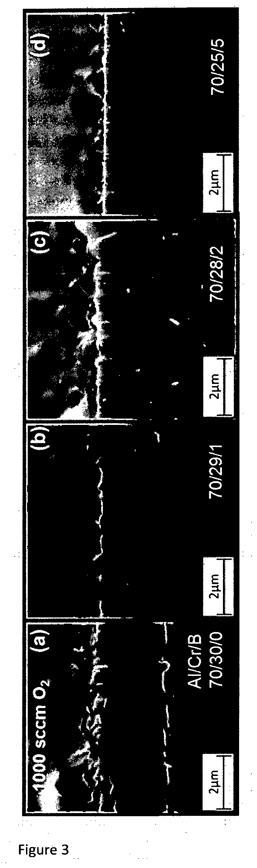

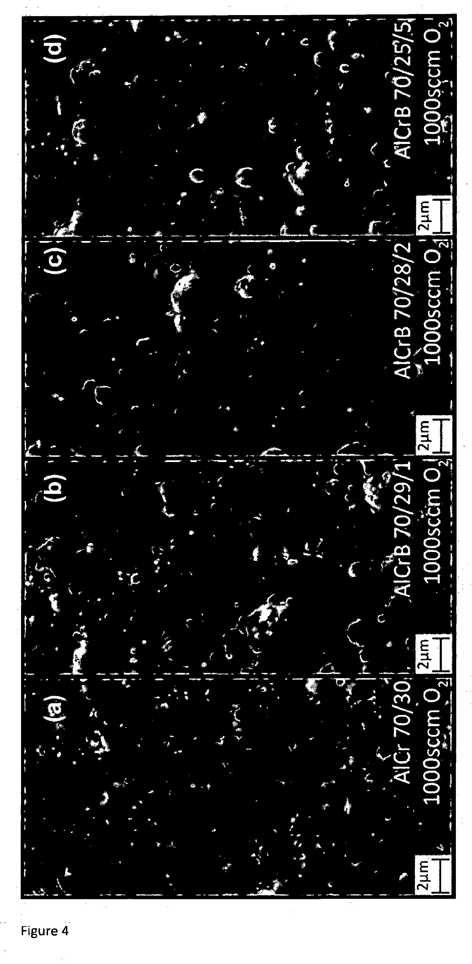

Figure 2 shows the X-ray diffractograms for the corresponding Al-Cr-B-O coatings which were synthesized from these targets. No improvement or stabilization of the corundum structure could be detected for all of these coatings in comparison to the coating obtained from the un-doped target. This means that B doping effectively helps to avoid the formation of oxide islands, however, does not support the corundum structure in the coating with increasing B content according to the X-ray measurements. Yet another influence of the B doping could be detected on the morphology of the Al-Cr-B-O coatings. The morphology became denser with increasing B content in the Al-Cr-B-O coatings, which is reflected in Figure 3 (a-d), where scanning electron microscopy (SEM) fracture cross sections of the synthesized coatings from the Al-Cr-B targets with 70/30/0, 70/29/1, 70/28/2, and 70/25/5, respectively, are presented. This refinement of the coating morphology goes along with reduced droplet density and thus a smoother surface of the Al-Cr-B-O coatings with increasing B content, compared to the un-doped Al-Cr-O coatings, see Figure 4 (a-d) for comparison.

3:
Particularly, using targets comprising aluminium (Al) and chromium (Cr) as main components and additionally minor fractions of Fe, it was possible to produce Al-Cr-Fe-O coatings exhibiting increased Al/Cr ratio and a strongly stabilized corundum structure. The coating processes were conducted at substrate temperatures of 600 °C and below. Surprisingly, in this way, it was possible to replace substantially and in some cases even completely Cr with Fe in the (Al,Cr)₂O₃ structure and still anyhow to achieve formation of corundum structures in the coating for high Al contents, inclusive for Al contents in the coating up to 90 at.%.

In a series of experiments using powder metallurgical Al-Cr-Fe targets having Fe additions of 1, 2 and 5 at.%, where Fe replaces Al as well as Cr. The obtained results are shown in Table 1.

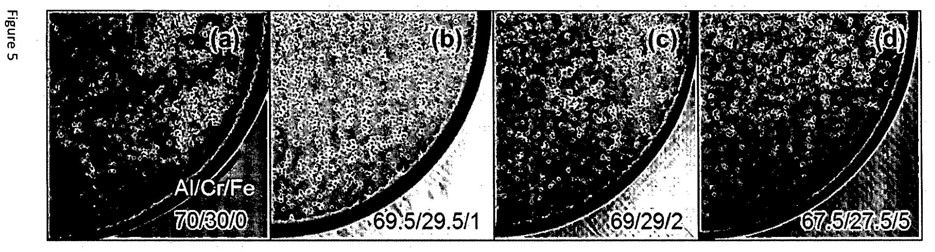

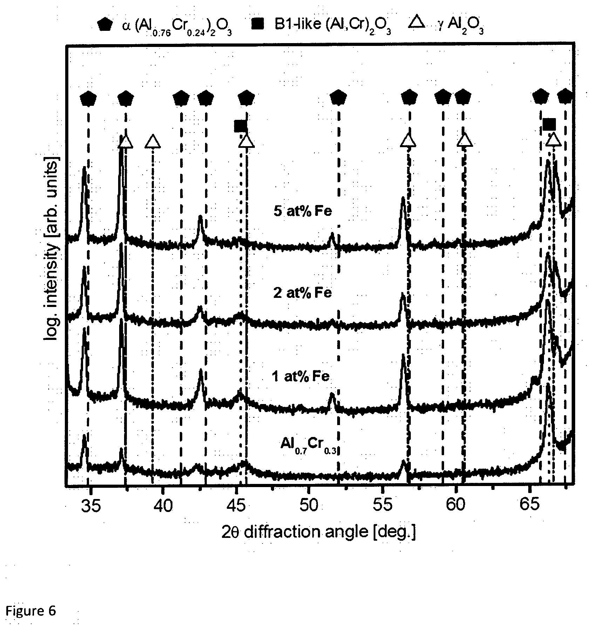

In contrast to B, the target oxide island formation could not be significantly influenced using Al-Cr-Fe-targets with Fe content ranging from 1 to 5 at%. This is demonstrated in Figure 5, where segments of the Al-Cr-Fe targets with 70/30/0 (a), 69.5/29.5/1 (b), 69/29/2 (c), and 67.5/27.5/5 (d) at.% are shown after operation in 1000 sccm oxygen flow at 550°C for 90 min. Nevertheless, X-ray analysis and transmission electron microscopy examinations indicated that even low amounts of Fe in the Al-Cr-Fe-targets can increase the peak intensity of the corundum structure drastically and reduce the formation of cubic crystalline structure in the produced aluminium chromium oxide coatings, allowing in this way the formation of the corundum structure. This trend can be seen in the XRD pattern in Figure 6, where the peak intensity of the peaks at e.g. 34.5 and 37.0 increases with increasing amount of Fe in the coatings.

### Tables and Figures:

- Table 1:: List of exemplary target compositions and corresponding coating compositions, measured by EDX and ERDA. The composition of the Al-Cr-O and Al-Cr-Fe-O coatings could be measured by EDX, whereas for determination of the B-content ERDA measurements were performed.
- Figure 1:: Cathode surface images of Al-Cr-B-cathodes after operation for 90 min at 550°C in oxygen atmosphere (flow of 1000 sccm O2). From (a) to (d) the B-content in the target increases from 0 at.% to 5 at.% at the expense of Cr, which results in an effective reduction of oxide island formation, as to be seen in the magnified subsegments of the targets.
- Figure 2:: X-ray pattern of Al-Cr-B-O coatings, deposited in 1000 sccm oxygen flow, at 550°C for 90 min.
- Figure 3:: SEM-cross sections of Al-Cr-B-O coatings, deposited in 1000 sccm oxygen flow, at 550°C for 90 min. Densification of coating structure, as well as lower amount of droplets, is visible with increased B-content from (a) to (d) with increasing B content in the coating.
- Figure 4:: SEM surface images of of Al-Cr-B-O coatings, deposited in 1000 sccm oxygen flow, at 550°C for 90 min. Increasing B content in the coatings from (a) to (d), results in a reduction of droplets in the coatings and thus smoother surface topographies.
- Figure 5:: Cathode surface images of Al-Cr-Fe cathodes after operation for 90 min at 550°C in oxygen atmosphere (flow of 1000 seem O2). From left to right, (a) to (d) the Fe-content in the target increases from 0 to 5 at.%, respectively, which has no effect on the formation of oxide islands.
- Figure 6:: X-ray pattern of Al-Cr-Fe-O coatings, deposited in 1000 sccm oxygen flow, at 550°C for 90 min, where a significant increase of the corundum type structure in the coatings can be observed with increasing Fe content in the coating. The indicated Fe contents refer to the target compositions.

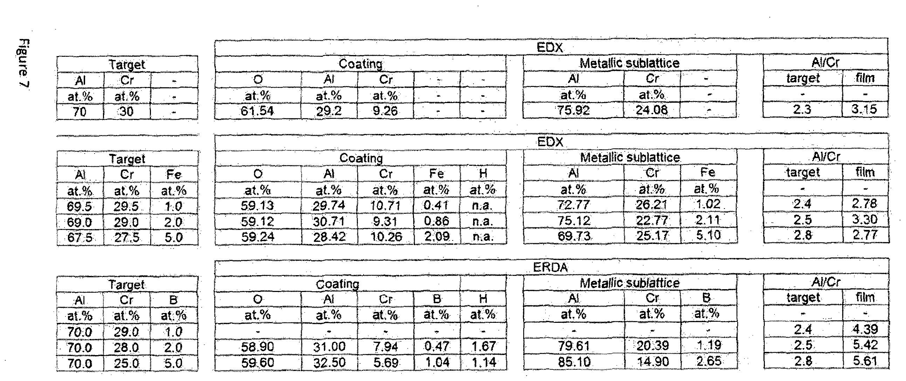

- Figure 7:: Shows table 1

### Concise description of the invention:

Concretely, the present invention relates to a coating method for coating a substrate with at least one aluminium oxide comprising coating layer, the layer being produced by physical vapour deposition from at least one target, preferably a metallic target, comprising aluminium as main component in a coating chamber containing oxygen as reactive gas, characterized in that:
- the target further comprises chromium as second main component and boron as minor component or iron as minor component or boron and iron as minor components,
   or
- the target further comprises iron as minor component.

Preferably, the target is made by powder metallurgy.

According to a preferred embodiment of the present invention, the physical vapour deposition process is a sputtering process, or a magnetron sputtering process, or a high power impulse magnetron sputtering process, or a cathodic arc evaporation process.

The substrate temperature during coating process should not be higher than 600 °C, preferably it should not be higher than 550 °C.

Preferably, during the physical vapour deposition a bias voltage is applied to the substrate that is being coated.

Preferably, the oxygen contained in the coating chamber is introduced by using a total oxygen flow of at least 300 sccm, in some cases more preferably of at least 1000 sccm.

Also in some cases using an oxygen partial pressure in the coating chamber of about 1.1 Pa could be advantageously.

If the target comprises aluminium and chromium, the target can be used for producing an aluminium chromium oxide based coating layer, In this case an atomic ratio Al/Cr higher than 2 in the target can be advantageously. A ratio Al/Cr of approximately 70/30, or higher than 70/30, can be particularly advantageously for some applications, such as for coating cutting tools.

If the target comprises aluminium and iron only, the target can be used for producing an aluminium iron oxide coating layer and the atomic ratio Al/Fe in the target is at least 70/30, preferably Al/Fe > 70/30.

If the target comprises boron, the boron content in atomic percentage in the target should not be higher than 20 at.-%. Boron contents in the target between 1 at.-% and 5 at.-% can be particularly advantageously for some applications. The sum of boron content and iron content should be preferably between 1 at.-% and 5 at.-%.

A method according to the present invention, in which a target comprising aluminium, chromium and boron is used, the boron content helps to reduce or prevent the formation of oxide islands at the surface of targets comprising aluminium and chromium as main components which are used for depositing aluminium chromium oxide comprising coating layers in oxygen reactive atmospheres.

A method according to the present invention, in which a target comprising aluminium, chromium and iron is used, the iron content promotes the formation of (Al,Cr)₂O₃ corundum structures in the aluminium chromium oxide comprising coating layer.

Furthermore the present invention relates to a body coated with a coating comprising at least one aluminium chromium oxide comprising coating layer produced by using a coating method according to one of the embodiments of the present invention described above, in which boron comprising aluminium chromium targets are used for producing aluminium chromium oxide comprising coating layers. The so produced layer should have a boron content in atomic percentage between 1 at.-% and 5 at.-% or lower, and consequently, the film morphology of the aluminium chromium oxide comprising coating layer produced in this way will be denser in comparison with a similar produced aluminium chromium oxide comprising coating layer but doesn't containing boron.

Similarly, the present invention relates to a body coated with a coating comprising at least one aluminium chromium oxide comprising coating layer produced by using a coating method according to one of the embodiments of the present invention described above, in which iron comprising aluminium chromium targets are used for producing aluminium chromium oxide comprising coating layers. The so produced layer should have an iron content in atomic percentage between 1 at.-% and 5 at.-% or lower. The aluminium chromium oxide comprising coating layer produced in this way will exhibit corundum structure or at least largely corundum structure.

Also similarly, the present invention relates to a body coated with a coating comprising at least one aluminium iron oxide comprising coating layer produced by using a coating method according to one of the embodiments of the present invention described above, in which iron comprising aluminium targets are used for producing aluminium iron oxide comprising coating layers. The so produced layer should have an iron content in atomic percentage not higher than 30 at.-%, preferably lower. The aluminium iron oxide comprising coating layer produced in this way will be exhibit corundum structure or at least largely corundum structure. This kind of aluminium iron oxide layers should be deposited in order to have an element composition given by the formula (Al, Fe)₂₋ₓO_{3-y} with x < 0.2 and y < 0.2.

## Claims

1. Coating method for coating a substrate with at least one aluminium oxide comprising coating layer, the layer being produced by physical vapour deposition from at least one target comprising aluminium as main component in a coating chamber containing oxygen as reactive gas, **characterized in that**:
• the target further comprises chromium as second main component and boron and iron as minor components and the sum of boron content and iron content is between 1 at.-% and 5 at.-% and the atomic ratio Al/Cr in the target is > 2.

2. Method according to claim 1, **characterized in that** the target is made by powder metallurgy.

3. Method according to claims 1 or 2, **characterized in that** the physical vapour deposition process is a sputtering process, or a magnetron sputtering process, or a high power impulse magnetron sputtering process, or a cathodic arc evaporation process.

4. Method according to claim 1 or 2, **characterized in that** the substrate temperature during coating process is not higher than 600 °C, preferably not higher than 550 °C.

5. Method according to any of the previous claims 1 to 4, **characterized in that** during the physical vapour deposition a bias voltage is applied to the substrate that is being coated.

6. Method according to any of the previous claims 1 to 5, **characterized in that** the oxygen contained in the coating chamber is introduced by using a total oxygen flow of at least 300 sccm, preferably of at least 1000 sccm.

7. Method according to any of the previous claims 1 to 6, **characterized in that** the oxygen partial pressure in the coating chamber is about 1.1 Pa.

8. Method according to any of the previous claims 1 to 7, **characterized in that** the target comprises aluminium and chromium and the atomic ratio Al/Cr in the target is higher than 2, preferably Al/Cr is 70/30, more preferably Al/Cr > 70/30.

9. Method according to any of the previous claims 1 to 8, **characterized in that** the target comprises aluminium and iron and the atomic ratio Al/Fe in the target is at least 70/30, preferably Al/Fe > 70/30.

10. Method according to claim 9, **characterized in that** the boron content in the target reduces or prevents the formation of oxide islands at the target surface during the deposition of the aluminium chromium oxide comprising coating layer.

11. Method according to claim 9 or 10, **characterized in that** the iron content in the target promotes the formation of (Al,Cr)₂O₃ corundum structures in the aluminium chromium oxide comprising coating layer.

12. Body coated with a coating comprising at least one aluminium chromium oxide comprising coating layer produced by using a coating method according to one of claims 1 to 11, **characterized in that** the coating has a boron content between 1 at.-% and 5 at.-%.

13. Body coated with a coating comprising at least one aluminium chromium oxide comprising coating layer produced by using a coating method according to one of claims 9 to 11, **characterized in that** the iron content in the aluminium chromium oxide comprising coating layer in atomic percentage is between 1 at.-% and 5 at.-%, and the aluminium chromium oxide comprising coating layer exhibits corundum structure.

## Patentansprüche

1. Beschichtungsverfahren, um ein Substrat mit zumindest einer Aluminiumoxid enthaltenden Schichtlage zu beschichten, wobei die Lage durch einen PVD-Prozess von zumindest einem Target, welches Aluminium als Hauptkomponente umfasst, in einer Beschichtungskammer, die Sauerstoff als reaktives Gas enthält, hergestellt wird, **dadurch gekennzeichnet, dass**:
- das Target des weiteren Chrom als zweite Hauptkomponente und Bor und Eisen als Nebenkomponenten umfasst, und die Summe des Bor- und des Eisengehalts zwischen 1 at.-% und 5 at.-% und das atomare Verhältnis Al/Cr im Target grösser als 2 ist.

2. Verfahren nach Anspruch 2, **dadurch gekennzeichnet, dass** das Target mittels Pulvermetallurgie hergestellt wurde.

3. Verfahren nach Anspruch 1 oder 2, **dadurch gekennzeichnet, dass** der PVD-Prozess ein Sputterprozess, oder ein Magnetron Sputterprozess, oder ein Hochleistungsimpuls Magnetron-Sputterprozess, oder ein kathodischer Funkenverdampfungsprozess ist.

4. Verfahren nach Anspruch 1 oder 2, **dadurch gekennzeichnet, dass** die Substrattemperatur während des PVD-Prozesses nicht höher als 600 °C, bevorzugterweise nicht höher als 550 °C ist.

5. Verfahren nach einem der vorhergehenden Ansprüche 1 bis 4, **dadurch gekennzeichnet, dass** während des PVD-Prozesses eine Bias-Spannung an das Substrat, welches beschichtet wird, angelegt ist.

6. Verfahren nach einem der vorhergehenden Ansprüche 1 bis 5, **dadurch gekennzeichnet, dass** der in der Beschichtungskammer enthaltene Sauerstoff durch Verwendung eines GesamtSauerstoff-Flusses von zumindest 300 sccm, bevorzugt von zumindest 1000 sccm eingeführt wird.

7. Verfahren nach einem der vorhergehenden Ansprüche 1 bis 6, **dadurch gekennzeichnet, dass** der Sauerstoffdruck in der Beschichtungskammer circa 1.1 Pa ist.

8. Verfahren nach einem der vorhergehenden Ansprüche 1 bis 7, **dadurch gekennzeichnet, dass** das Target Aluminium und Chrom umfasst und das atomare Verhältnis Al/Cr grösser als 2, dabei bevorzugt Al/Cr gleich 70/30, insbesondere bevorzugt Al/Cr > 70/30 ist.

9. Verfahren nach einem der vorhergehenden Ansprüche 1 bis 8, **dadurch gekennzeichnet, dass** das Target Aluminium und Eisen umfasst und das atomare Verhältnis Al/Fe zumindest 70/30, dabei bevorzugt Al/Cr > 70/30 ist.

10. Verfahren nach Anspruch 9, **dadurch gekennzeichnet, dass** der Borgehalt im Target die Bildung von Oxidinseln auf der Targetoberfläche während der Abscheidung der Aluminium-Chrom-Oxid enthaltenden Schichtlage verringert oder verhindert.

11. Verfahren nach Anspruch 9 oder 10, **dadurch gekennzeichnet, dass** der Eisengehalt im Target die Bildung von (Al,Cr)₂O₃-Korundstrukturen in der Aluminium-Chrom-Oxid enthaltenden Schichtlage fördert.

12. Gegenstand, der durch Verwendung eines Beschichtungsverfahrens nach einem der Ansprüche 1 bis 11 hergestellt wird und zumindest eine Aluminium-Chrom-Oxid umfassende Schichtlage umfasst, **dadurch gekennzeichnet, dass** die Beschichtung einen Borgehalt zwischen 1 at.-% und 5 at.-% hat.

13. Gegenstand, der durch Verwendung eines Beschichtungsverfahrens nach einem der Ansprüche 1 bis 11 hergestellt wird und zumindest eine Aluminium-Chrom-Oxid umfassende Schichtlage umfasst, **dadurch gekennzeichnet, dass** gekennzeichnet, dass der Eisengehalt in der Aluminium-Chrom-Oxid umfassenden Schichtlage in Atomprozent zwischen 1 at.-% und 5 at.-% ist und die Aluminium-Chrom-Oxid umfassende Schichtlage eine Korundstruktur aufweist.

## Revendications

1. Procédé de revêtement pour revêtir un substrat avec au moins une couche de revêtement comprenant de l'oxyde d'aluminium, la couche étant produite par dépôt physique en phase vapeur à partir d'au moins une cible comprenant de l'aluminium comme composant principal dans une chambre de revêtement contenant de l'oxygène comme gaz réactif, **caractérisé en ce que** la cible comprend en outre du chrome comme deuxième composant principal et du bore et du fer comme composants mineurs, et **en ce que** la somme de la teneur en bore et de la teneur en fer est comprise entre 1 % atomique et 5 % atomique et le rapport atomique Al/Cr dans la cible est > 2.

2. Procédé selon la revendication 1, **caractérisé en ce que** la cible est fabriquée par métallurgie en poudre.

3. Procédé selon la revendication 1 ou 2, **caractérisé en ce que** le processus de dépôt physique en phase vapeur est un processus de pulvérisation, ou un processus de pulvérisation magnétron, ou un processus de pulvérisation magnétron à impulsion haute puissance, ou un processus d'évaporation par arc cathodique.

4. Procédé selon la revendication 1 ou 2, **caractérisé en ce que** la température du substrat pendant le processus de revêtement n'est pas supérieure à 600 °C, de préférence pas supérieure à 550 °C.

5. Procédé selon l'une des revendications 1 à 4, **caractérisé en ce que**, pendant le dépôt physique en phase vapeur, il est appliqué une tension de polarisation au substrat qui est en train d'être revêtu.

6. Procédé selon l'une des revendications 1 à 5, **caractérisé en ce que** l'oxygène contenu dans la chambre de revêtement est introduit à un débit d'oxygène total d'au moins 300 sccm, de préférence d'au moins 1 000 sccm.

7. Procédé selon l'une des revendications 1 à 6, **caractérisé en ce que** la pression partielle d'oxygène dans la chambre de revêtement est d'environ 1,1 Pa.

8. Procédé selon l'une des revendications 1 à 7, **caractérisé en ce que** la cible comprend de l'aluminium et du chrome et **en ce que** le rapport atomique Al/Cr dans la cible est supérieur à 2, le rapport Al/Cr étant de préférence de 70/30, de façon davantage préférée > 70/30.

9. Procédé selon l'une des revendications 1 à 8, **caractérisé en ce que** la cible comprend de l'aluminium et du fer et **en ce que** le rapport atomique Al/Fe dans la cible est d'au moins 70/30, de préférence > 70/30.

10. Procédé selon la revendication 9, **caractérisé en ce que** la teneur en bore dans la cible réduit ou empêche la formation d'îles d'oxyde à la surface de la cible pendant le dépôt de la couche de revêtement comprenant de l'oxyde de chrome et d'aluminium.

11. Procédé selon la revendication 9 ou 10, **caractérisé en ce que** la teneur en fer dans la cible favorise la formation de structures de corindon (Al,Cr)₂O₃ dans la couche de revêtement comprenant de l'oxyde de chrome et d'aluminium.

12. Corps revêtu d'un revêtement comprenant au moins une couche de revêtement comprenant de l'oxyde de chrome et d'aluminium fabriqué à l'aide du procédé de revêtement selon l'une des revendications 1 à 11, **caractérisé en ce que** le revêtement a une teneur en bore comprise entre 1 % atomique et 5 % atomique.

13. Corps revêtu d'un revêtement comprenant au moins une couche de revêtement comprenant de l'oxyde de chrome et d'aluminium fabriqué à l'aide du procédé de revêtement selon l'une des revendications 9 à 11, **caractérisé en ce que** la teneur en fer dans la couche de revêtement comprenant de l'oxyde de chrome et d'aluminium est comprise, en pourcentage atomique, entre 1 % atomique et 5 % atomique, et **en ce que** la couche de revêtement comprenant de l'oxyde de chrome et d'aluminium présente une structure de corindon.
